Europäisches Patentamt

European Patent Office

Office européen des brevets

(11) Numéro de publication: **0 087 349**
**A1**

## (12) DEMANDE DE BREVET EUROPEEN

(21) Numéro de dépôt: 83400278.4

(22) Date de dépôt: 09.02.83

(51) Int. Cl.³: **H 05 K 7/14**

(30) Priorité: 16.02.82 FR 8202509

(43) Date de publication de la demande:
31.08.83 Bulletin 83/35

(84) Etats contractants désignés:
AT BE CH DE GB IT LI LU NL SE

(71) Demandeur: TRANSRACK
20-22 Avenue Raspail
F-94100 Saint Maur(FR)

(72) Inventeur: Meggs, Jean-Pierre
58, rue Salengro
F-93140 Bondy(FR)

(74) Mandataire: CABINET BONNET-THIRION
95 Boulevard Beaumarchais
F-75003 Paris(FR)

(54) Bac pour cartes de circuits, destiné notamment aux coffrets et baies d'appareillages électroniques.

(57) L'invention concerne un bac pour appareillage, notamment électronique, destiné à recevoir des cartes de circuits tels que des circuits imprimés, du type comportant sous la forme de pièces distinctes deux flasques reliés par des poutres.

Le bac est caractérisé en ce que les flasques (1) sont des pièces moulées comportant des moyens d'assemblage à emboîtement et verrouillage (14, 141, 142, 15) destinés à coopérer avec des moyens d'assemblage à emboîtement et verrouillage (21, 22) correspondants prévus sur des poutres (2) destinées à être assemblées avec lesdits flasques.

L'invention est applicable notamment aux systèmes électroniques, pneumatiques et fluidiques, ainsi qu'automatiques et informatiques.

./...

FIG.1

**"Bac pour cartes de circuits, destiné notamment aux coffrets et baies d'appareillages électroniques"**

La présente invention concerne un bac pour appareillage, notamment électronique, destiné à recevoir des cartes de circuits, tels que des circuits imprimés.

On connaît déjà de tels bacs réalisés sous la forme d'un assemblage de pièces distinctes, de telle sorte qu'à partir des mêmes pièces puissent être créés des bacs de dimensions et de formes différentes adaptés à recevoir selon la configuration désirée des cartes de circuits imprimés par exemple. Ces bacs nécessitent des moyens d'assemblage par vissage ou boulonnage, et l'adaptation des cartes de circuits implique le montage d'accessoires supplémentaires, opération souvent longue et minutieuse, et par conséquent dispendieuse.

On connaît également des bacs en matière plastique moulée sous forme monobloc, présentant donc l'inconvénient de ne se prêter qu'à des applications figées et dont le volume important nécessite des surfaces de stockage et moyens de magasinage conséquent.

L'invention a pour but de remédier à ces inconvénients, et concerne à cet effet un bac pour appareillage, notamment électronique, destiné à recevoir des cartes de circuits tels que des circuits imprimés, du type comportant sous la forme de pièces distinctes deux flasques reliés par des poutres, bac caractérisé en ce que les flasques sont des pièces moulées comportant des moyens d'assemblage à emboîtement et verrouillage destinés à coopérer avec des moyens d'assemblage à emboîtement et verrouillage correspondants prévus sur des poutres destinées à être assemblées avec les dits flasques.

Bien que, préférentiellement, les flasques du bac selon l'invention soient destinés à être assemblés aux poutres spécialement prévues à cet effet, selon une caractéristique de l'invention, ils peuvent être munis de moyens d'assemblage classiques permettant de les assembler à des poutres classiques par exemple par vissage ou boulonnage.

Selon une autre caractéristique, avantageuse, de l'invention, le bac comporte des poutres munies d'au moins deux séries de moyens guide-cartes faisant partie intégrante desdites poutres, lesdites deux séries ayant un module différent.

Ainsi, l'utilisateur peut choisir différents écartements entre deux cartes voisines, et en particulier, deux écartements réguliers de modules différents.

D'autres caractéristiques et avantages de l'invention ressortiront d'ailleurs de la description qui va suivre, se rapportant à une forme de réalisation donnée à titre d'exemple non limitatif et représentée sur les dessins annexés dans lesquels :

la figure 1 est une vue en perspective explosée d'un bac selon l'invention, où sont représentées seulement deux poutres de liaison des flasques ;

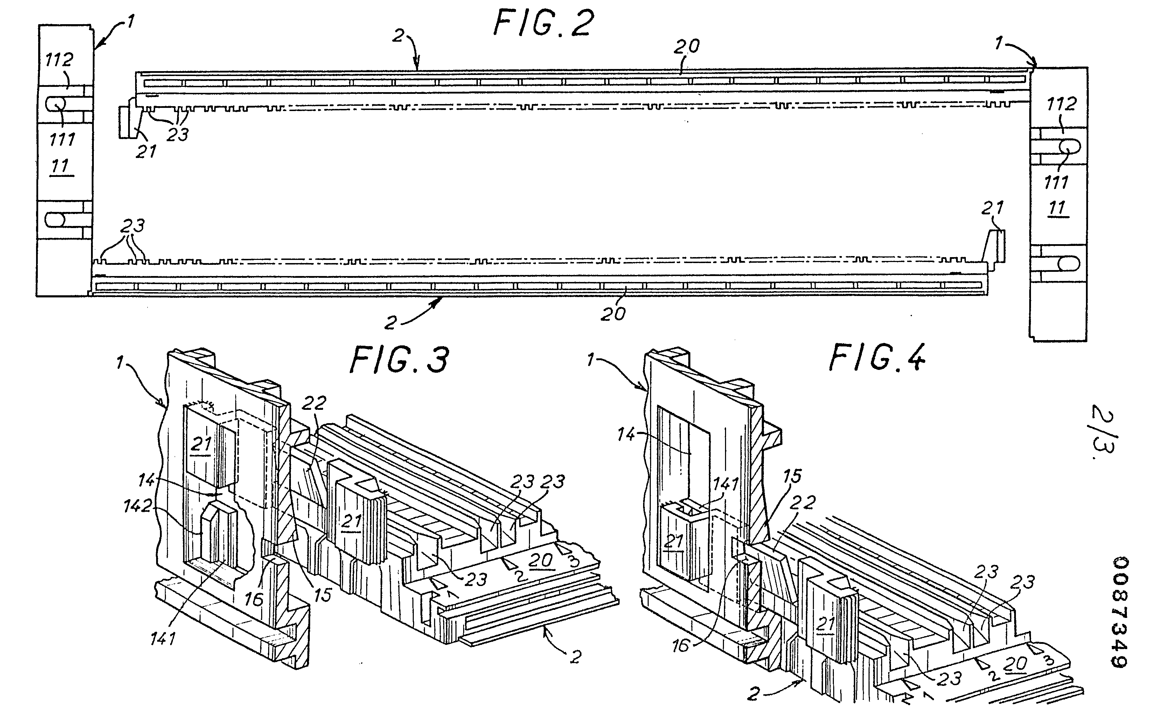

la figure 2 est une vue de face du bac de la figure 1, sur laquelle chacune des deux poutres est représentée assemblée à un flasque différent ;

la figure 3 est une vue en perspective partiellement coupée montrant un détail de la figure 1, un flasque et une poutre ayant été rapprochés mais non assemblés ;

la figure 4 est une vue montrant les pièces de la figure 3 dans la position qu'elles occupent lorsqu'elles sont assemblées ;

la figure 5 est une vue en perspective montrant un clip de fixation de porte-connecteur destiné à un bac selon l'invention ;

la figure 6 est une section transversale d'un détail d'une poutre selon l'invention montrant le montage du clip de la figure 5.

Le bac selon l'invention, représenté sur les dessins, est constitué de deux flasques 1 et de quatre poutres 2 de liaison des flasques, seules deux poutres étant représentées sur les dessins.

Les deux flasques 1 sont identiques et disposés de manière à se faire vis-à-vis parallèlement, symétriquement par rapport à un plan vertical de symétrie ; ils sont conçus pour se monter indifféremment dans les baies et les coffrets de la même manière que dans le cas des bacs usuels.

Les quatre poutres, et notamment les poutres 2 sont également identiques ; elles sont disposées de manière à se faire vis-à-vis deux à deux, parallèlement, symétriquement par rapport à un plan horizontal de symétrie ; elles comportent de manière monobloc des moyens guide-cartes avec une modulation particulière de leur emplacement longitudinal.

Les bacs ainsi assemblés sont en accord avec les normes N.F.C. 20150 et D I N 41494, publication CEI 297 et sous Comité 48D concernant la réalisation d'ensembles mécaniques destinés à recevoir des circuits imprimés aux dimensions mécaniques internationales 100 X 160, 100 X 220, 100 X 280, 233,4 X 160, 233,4 X 220, 233,4 X 280 ; ils sont réalisés en plusieurs hauteurs, par exemple de 2 U à 6 U (U représentant l'unité connue sous le nom d'"unité rack de 44,45 mm") ; si la hauteur est relativement grande (par exemple 6 U , il est utile d'adjoindre une entretoise arrière).

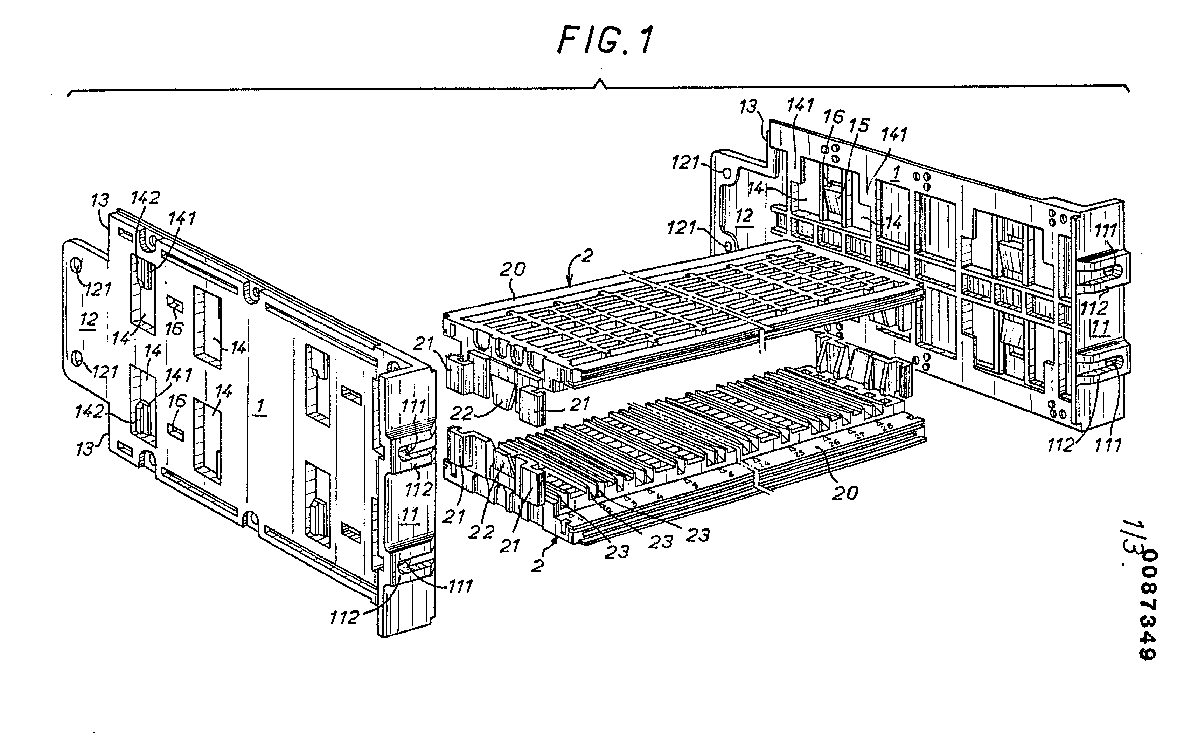

En vue d'effectuer les raccordements nécessaires, le bac peut comporter également une carte mère, ou un cadre ou des barrettes porte-connecteurs, et des clips de fixation de ces organes, non représentés sur la figure 1.

D'une manière générale, ce bac, en accord avec les normes européennes, présente comme caractéristique que les flasques et les poutres comportent des moyens d'assemblage à emboîtement et verrouillage destinés à coopérer en vue d' obtenir un assemblage par interpénétration facile et sûr. Ces flasques et ces poutres sont en un matériau moulé, pouvant être une matière thermoplastique par exemple, injectée, ou un métal tel qu'un alliage de zinc ou d'aluminium ; lorsque les flasques et les poutres sont en matière plastique, celle-ci peut être chargée de verre et de préférence auto-extinguible.

Les flasques peuvent comporter des moyens d'assemblage classiques par exemple par vissage ou boulonnage, de telle sorte qu'ils puissent être assemblés à des poutres conventionnelles.

Les flasques 1 sont des pièces monobloc comportant à l'avant un rebord 11 coudé à 90 degrés leur donnant un profil en L.

Le rebord 11 comporte des perforations 111, par exemple deux ou quatre selon la hauteur, destinées à la fixation du bac sur les baies, coffrets, ou armoires électroniques, ici au standard international ; ces perforations 111 sont entourées d'un bossage 112 servant de renfort pour la fixation sur la paroi avant (non représentée) du coffret ou de la baie.

La largeur des rebords 11 et la longueur des poutres 2 permettent d'obtenir une largeur totale de face avant du bac assemblé de 482,6 mm $^{+\ 0,4}_{-\ 0,0}$.

A l'arrière, les flasques 1 comportent des oreilles 12 dans le prolongement de leur plan, au-delà d'un plan de connexion défini par l'emplacement des connecteurs du bac, ici au voisinage du plan de chants 13, tournés vers l'arrière, des flasques.

Ainsi, les connecteurs sont protégés lors des manipulations du bac en dehors de son armoire, notamment lorsque celui-ci est posé debout, par exemple à l'occasion d'un dépannage.

Les oreilles 12 permettent également le montage d'un châssis arrière, porte-accessoires, par exemple par boulonnage dans des perforations 121.

L'assemblage des flasques et des poutres s'effectuant par interpénétration, les parties haute et basse du flasque 1 comportent chacune une rangée horizontale d'ajourages rectangulaires 14 recevant les extrémités des poutres 2, et plus précisément des tenons réalisés à ces extrémités, comme il sera vu plus loin ; dans le cas présent, où il est prévu un seul niveau de cartes disposées verticalement en rangées horizontales, il n'y a que deux rangées horizontales d'ajourages, mais, en règle générale, il y a autant de paires de rangées horizontales d'ajourages que de niveaux pour les cartes. Les ajourages 14 sont munis intérieurement, dans un coin, d'une languette rigide 141 de positionnement des poutres présentant une hauteur et une largeur légèrement inférieures à la moitié respectivement de la hauteur et de la largeur de l'ajourage ; cette languette rigide 141 est munie d'une cale biaise 142, dont le plan incliné d'entrée facilite l'emboîtement avec le tenon de la poutre. Comme à chaque niveau de cartes verticales correspond au moins une poutre inférieure et au moins une poutre supérieure, les ajourages pour les poutres inférieures comportent une languette rigide à leur partie inférieure, et les ajourages pour les poutres supérieures comportent une languette rigide à leur partie supérieure.

Des moyens de butée assurent le verrouillage des profilés, notamment en rotation.

Ainsi, des rampes 15 sont prévues dans les faces des flasques 1 qui sont en regard l'une de l'autre, en vue de coopérer avec des languettes élastiques prévues aux extrémités des poutres ; des zones de fragilité défonçables 16 sont prévues dans le prolongement des rampes 15, juste à l'endroit de l'interruption de chaque rampe 15 du côté de la plus grande épaisseur de matière ; ces zones de fragilité défonçables 16 réalisées sous la forme de zones minces, sont représentées sur les figures dans leur état après défonçage ; leur rôle sera expliqué plus loin.

Les flasques comportent également des perforations ou des trous fraisés ou lamés permettant le montage par vissage ou boulonnage de poutres conventionnelles, par exemple sous la forme de profilés d'aluminium (ou autre) de façon à constituer une ossature mixte.

Les poutres 2 sont également des pièces monobloc, comportant un socle 20, et, à leurs extrémités des tenons 21 destinés à s'emboîter dans les ajourages 14 des flasques 1, et des languettes élastiques 22 destinées à coopérer avec les rampes 15. Ces éléments de liaison des flasques permettent d' obtenir ici une largeur utile de 426,72 mm.

Le plan des tenons 21 est disposé perpendiculairement à celui du socle des poutres, les tenons étant au-dessus du socle pour les poutres inférieures, et au-dessous pour les poutres supérieures de chaque niveau de cartes verticales.

La hauteur des tenons 21 doit être suffisamment faible pour permettre d'introduire ceux-ci dans les ajourages 14, au-dessus ou au-dessous des languettes 141. Ces tenons 21 présentent une section horizontale en U ; les bases des U constituent les faces extrêmes des poutres 2, et la distance entre l'extrémité libre de la branche libre de chaque U et l'extrémité du socle 20 est supérieure à l'épaisseur des languettes 141 augmentée de celle des cales biaises 142, de telle sorte que les languettes et les cales puissent être insérées entre les tenons 21 et le socle 20 des poutres 2 en vue d'assurer un guidage vertical du mouvement des poutres 2 par rapport aux flasques 1 ; bien entendu, l'écartement des tenons 21 de chaque extrémité d'une même poutre est également adapté à l'écartement des ajourages 14 des flasques.

Entre les tenons 21, sont disposées les languettes élastiques 22, du même côté du socle 20 que les tenons 21. Ces languettes élastiques 22 sont reliées au socle 20 à l'une de leurs extrémités, et elles sont inclinées vers l'extérieur de telle sorte que les extrémités libres de deux languettes 22 situées à des extrémités opposées dudit socle 20 soient plus éloignées l'une de l'autre que leurs extrémités solidarisées au socle ; la hauteur des languettes est telle qu'une fois les poutres en place, leur extrémité libre soit verrouillée par les extrémités des rampes 15 en vue de bloquer les poutres en position.

Le guidage des cartes de circuits disposées verticalement, c'est-à-dire perpendiculairement au socle des poutres, est assuré par des rainures 23 parallèles s'étendant transversalement par rapport aux poutres et se succédant longitudinalement sur toute la longueur de celles-ci.

Afin que la distance entre deux cartes de circuits puisse être choisie parmi plusieurs valeurs possibles, selon l' invention, il est prévu qu'à partir d'une première rainure, il existe une première série de rainures ayant entre elles un premier écartement ou module, et au moins une seconde série de rainures ayant un second écartement ou module ; dans la mesure où il existe une unité de base pour les écartements de faible valeur, une bonne solution consiste à choisir deux modules dont les valeurs sont des multiples de l'unité de base, avec des facteurs multiplicatifs eux-mêmes de faible valeur, par exemple inférieurs à 10.

Ainsi, avec des facteurs multiplicatifs égaux respectivement à trois et quatre, si l'origine est prise à l'emplacement de la première rainure, et si on se réfère à l'unité de base pour les écartements, les rainures de la première série auront pour abscisses respectives :

0, 3, 6, 9, 12, 15 etc..,

et les rainures de la seconde série auront pour abscisses respectives :

0, 4, 8, 12, 16 etc.. ;

en conséquence, il y aura une rainure à chacune des abscisses suivantes :

0,3, 4, 6, 8, 9, 12, 15, 16 ..., et les rainures d' abscisses 0, 12, 24, 36, etc... seront communes aux deux séries, c'est-à-dire que ces rainures correspondront au pas de la série globale résultante ; de manière générale, ce pas est le plus petit commun multiple des deux facteurs multiplicatifs choisis.

Or, de manière classique, l'unité de base pour les écartements est de 5,08 mm, ce qui entraîne que les positions des rainures correspondant à la série précédente ont les abscisses suivantes :

0 mm, 15,24 mm, 20,32 mm, 30,48 mm, 40,64 mm, 45,72 mm, 60,96 mm, etc.., le pas étant de 60,96 mm.

Dans le cas présent, qui est celui qui vient d'être décrit, la longueur utile des poutres correspond à 84 fois 5,08 mm, c'est-à-dire 426,72 mm, ce qui implique la présence d'un groupe de rainures de guidage se répétant sept fois au pas de 60,96 mm, correspondant à une première série de rainures espacées de 15,24 mm et une seconde série de rainures espacées de 20,32 mm ; par ailleurs, les rainures font partie intégrante des poutres.

Il est par conséquent possible de disposer les cartes à intervalles réguliers, ou encore de les écarter de la distance considérée comme la plus appropriée parmi les distances possibles déterminées par la position des rainures.

Les composants et accessoires électroniques devant être montés dans les bacs étant eux-mêmes diversifiés en largeur, et leur connexion pouvant être effectuée selon divers écartements, la disposition des guidages permet ainsi de multiplier les possibilités d'équipement tout en conservant une surface ajourée compatible avec les besoins en aération.

Sur chaque poutre, des logements sont prévus pour recevoir des bandes-repère permettant le repérage des positions pour les cartes.

Sur le plan pratique, comme il existe différents types de cartes de circuits, il est possible de prévoir des ensembles pour cartes de longueurs 160 mm, 220 mm, 280 mm, etc...; en vue de pouvoir adapter un bac destiné à des cartes de dimension déterminée, à des cartes de la dimension inférieure, il est recommandé de prévoir des moyens d'assemblage à emboîtement et verrouillage supplémentaires, en retrait de 60 mm, et même éventuellement des moyens en retrait de 120mm ou selon toute autre configuration en vue de l'implantation désirée.

Le montage du bac, et plus précisément l'assemblage de chaque poutre 2 avec un flasque 1, est obtenu en introduisant les tenons 21 de la poutre dans les ajourages 14 choisis, et en faisant coulisser ces tenons 21 autour des languettes 141 et des cales biaises 142, le long de celles-ci ; au cours de ce coulissement, la languette élastique 22 de chaque extrémité de poutre se plie, sous l'action de la rampe 15 correspondante, jusqu'au moment où elle a totalement franchi cette rampe 15 ; l'emboîtement des tenons et des languettes 141 et des cales biaises 142 est alors réalisé, et, la languette 22 ayant repris sa position initiale, provoque le verrouillage du dispositif en bloquant la poutre en position par rapport au flasque.

Le déverrouillage peut cependant être obtenu en défonçant, de l'extérieur du bac, les zones de fragilité 16 à l'aide d'un outil, par exemple d'un tournevis ; il est alors possible de démonter la poutre correspondante en repoussant la languette élastique 22 tout en faisant coulisser les tenons 21 autour des languettes 141 et des cales biaises 142 en direction de la partie dégagée de l'ajourage 14.

Les connecteurs d'alimentation des cartes de circuits peuvent être montés, de manière classique, avec des barrettes porte-connecteurs ou une carte-mère, ou un cadre arrière.

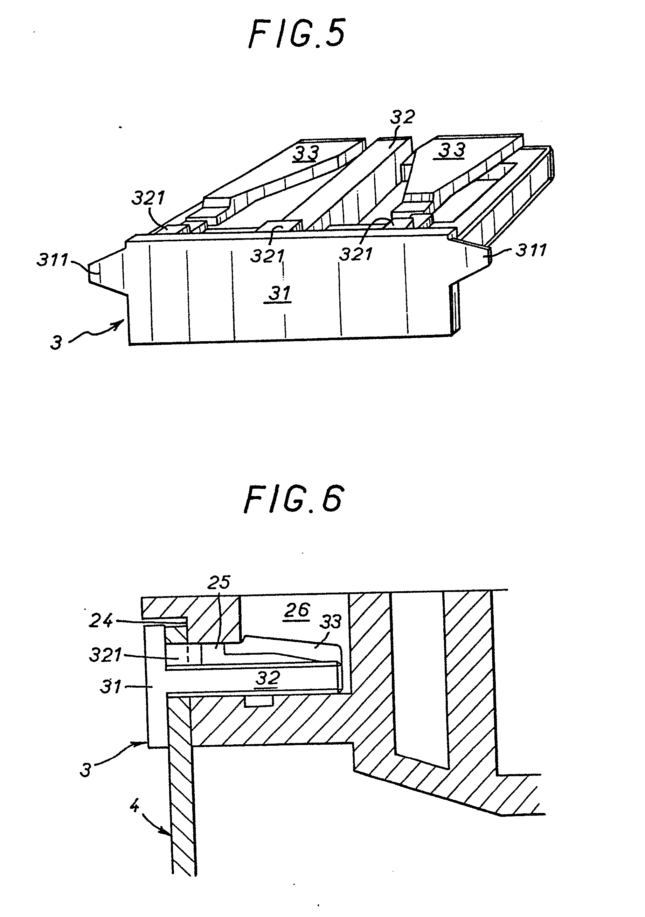

Le montage de la carte-mère, du cadre arrière, ou des barrettes porte-connecteurs peut être effectué par vissage ou par boulonnage dans le chant arrière des poutres 2 montées à l'arrière du bac, grâce à des alvéoles prévus à cet effet, ou encore à l'aide de clips élastiques 3 (figure 5), de préférence en matière plastique s'enclenchant dans une rainure 24 aménagée dans les chants longitudinaux des poutres 2 (figure 6).

Les accessoires d'immobilisation des faces avant des cartes de circuits peuvent être immobilisés également dans les alvéoles prévus dans les chants avant des poutres.

Les clips 3 de montage de la carte-mère, du cadre arrière ou des barrettes porte-connecteurs sont des pièces monobloc en matière plastique moulée, comportant essentiellement une face avant 31 munie d'ailettes latérales inclinées souples 311 de compensation d'épaisseur, raccordée à un châssis 32 à butées de positionnement 321, auquel sont articulées deux lamelles élastiques 33, à l'extrémité du châssis opposée à la face avant 31.

Ils sont destinés à être insérés dans des ajours 25 débouchant dans les rainures 24 prévues dans les chants arrière des poutres 2, la carte-mère 4 étant maintenue contre ces clips et le fond des rainures 24 ; des lumières 26 permettent l'expansion des lamelles élastiques 33 ; comme ces

lumières 26 débouchent dans les faces des poutres 2, il est possible d'appuyer sur les lamelles élastiques 33 afin de provoquer leur recul en vue du retrait des clips 3 des ajours 25, par exemple pour changer une carte de circuits.

Ces clips permettent un montage très simple, puisque, après avoir mis en contact les éléments à assembler (porte-connecteurs, cache, carte-mère 4) avec le chant des poutres choisies, les clips 3 sont introduits par pression dans les ajours 25. Les lamelles élastiques 33 traversent les accessoires porte-connecteurs dans les perforations prévues à cet effet, en s'escamotant, jusqu'au serrage complet des différentes pièces. En fin de course, les lamelles élastiques 33 sont libérées et remontent dans les lumières 26, de telle sorte qu'elles se mettent en butée contre une arête intérieure de la zone de transition entre l'ajour 25 et la lumière 26, ce qui assure le blocage de l'ensemble, avec compensation du jeu grâce à la traction exercée par les ailettes 311, qui prennent appui contre le porte-connecteur 4.

Le démontage est possible, comme il a été déjà vu plus haut, en exerçant une pression à l'aide d'un outil approprié sur les lamelles 33, en passant par les lumières 26.

Bien entendu, l'invention n'est pas limitée à la forme de réalisation ci-dessus décrite et représentée, et on pourra prévoir d'autres formes sans sortir du cadre de l'invention.

REVENDICATIONS

1. Bac pour appareillage, notamment électronique, destiné à recevoir des cartes de circuits tels que des circuits imprimés, du type comportant sous la forme de pièces moulées distinctes deux flasques reliés par au moins deux paires de poutres, bac caractérisé en ce que les flasques (1) comportent des moyens d'assemblage à emboîtement et verrouillage (14, 141, 142, 15) destinés à coopérer avec des moyens d'assemblage à emboîtement et verrouillage (21, 22) correspondants prévus sur des poutres (2) destinées à être assemblées avec lesdits flasques.

2. Bac selon la revendication 1, caractérisé en ce que les poutres (2) sont des pièces moulées monobloc.

3. Bac selon l'une quelconque des revendications 1 et 2, caractérisé en ce que les poutres (2) sont munies d'au moins deux séries de moyens guide-cartes (23) faisant partie intégrante desdites poutres, lesdites deux séries ayant un module différent.

4. Bac selon l'une quelconque des revendications 1 à 3, caractérisé en ce que les moyens d'assemblage des flasques comportent des ajourages (14) munis d'une languette (141) et d'une cale biaise (142), en vue de l'emboîtement des poutres (2) dans les flasques (1).

5. Bac selon l'une quelconque des revendications 1 à 4, caractérisé en ce que les moyens d'assemblage des flasques comportent des rampes 15 en vue de verrouillage des poutres (2) par rapport aux flasques (1).

6. Bac selon l'une quelconque des revendications 1 à 4, avec des moyens d'assemblage des poutres comportant des tenons, caractérisé par des tenons (21) présentant une section en U en vue de l'emboîtement des poutres (2) dans les flasques (1).

7. Bac selon l'une quelconque des revendications 1 à 5, caractérisé en ce que les moyens d'assemblage des poutres comportent des languettes élastiques (22) en vue du verrouillage des poutres (2) par rapport aux flasques (1).

8. Bac selon l'une quelconque des revendications 1 à 7, caractérisé en ce que les moyens guide-cartes sont des rainures (23) parallèles s'étendant transversalement aux poutres (2) et se succédant longitudinalement sur toute la longueur de celles-ci en deux séries définies par des modules de répétition correspondant à deux multiples distincts d'une unité de base.

9. Bac selon l'une quelconque des revendications 1 à 8, caractérisé en ce qu'il comporte, pour la fixation de porte-connecteurs, des clips (3) introduits dans des ajours (25) prévus dans les poutres (2), ces clips (3) étant munis de lamelles élastiques (33) dont l'expansion dans des lumières (26) prévues également dans les poutres (2) provoque le blocage du clip (3) et la fixation du porte-connecteur (4).

10. Bac selon l'une quelconque des revendications 1 à 9, caractérisé en ce qu'il comporte au moins une pièce (1,2,3) en matière plastique.

11. Bac selon l'une quelconque des revendications 1 à 10, caractérisé en ce qu'il comporte au moins une pièce (1, 2,3) en alliage métallique.

# FIG.1

0087349

FIG.2

FIG.3

FIG.4

2/3.

0087349

# FIG.5

# FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| Y | FR-A-1 461 268 (HAV-TEK DESIGNERS INC.) <br> * Page 3, colonne 2, alinéa 2; figure 1 * | 1,6 | H 05 K 7/14 |
| Y | CH-A- 422 102 (SIEMENS & HALSKE) <br> * Page 2, lignes 14-53 * | 1,6 | |
| X | US-A-3 733 523 (AMPEX CORP.) <br> * Colonne 2, lignes 46-67; figure 1 * | 2 | |
| A | FR-A-2 197 302 (MERLIN GERIN) | | |
| A | US-A-4 232 356 (BURROUGHS CORP.) | | |
| A | US-A-3 755 630 (BELL CANADA) | | |

DOMAINES TECHNIQUES RECHERCHES (Int. Cl. 3)

H 05 K 7/00
H 05 K 5/00

Le présent rapport de recherche a été établi pour toutes les revendications

| Lieu de la recherche | Date d'achèvement de la recherche | Examinateur |
|---|---|---|
| LA HAYE | 14-06-1983 | SCHUERMANS N.F.G. |